# EUROPEAN PATENT APPLICATION

(11) **EP 0 895 292 A1**
(43) Date of publication of application: **03.02.1999**
(21) Application number: 97305686.4
(22) Date of filing: 29.07.1997
(51) Int. Cl.: H01L 33/00

(54) **Electroluminescent device**

(71) Applicant: HITACHI EUROPE LIMITED, Maidenhead, Berkshire, SL6 8YA (GB)
(72) Inventor: Alphenaar, Bruce William, Cambridge CB3 OHW (GB); Nakazato, Kazuo, Cambridge, CB2 2RP (GB)
(74) Representative: Read, Matthew Charles

(57) **Abstract**

An electroluminescent device consists of a superlattice 3 containing layers of undoped silicon 1 separated by tunnel barrier junction layers 2. The silicon layers 1 are of a thickness of 5 nm or less such that the indirect band gap silicon material exhibits direct band gap electroluminescent characteristics. Charge carriers of opposite conductivity type are injected into the superlattice and combine to produce electroluminescence.

## Description

This invention relates to an electroluminescent device formed of material which has an indirect band gap, such as silicon semiconductor material.

Silicon technology is widely used in electronic devices but has an indirect band gap and as a result is not particularly useful for optoelectronics.

For an indirect band gap semiconductor, an electron transferring from the top of the valence band to the bottom of the conduction band or vice versa, changes both its energy and momentum. In contrast, for a direct band gap semiconductor material, the electron changes only its energy and not its momentum. Examples direct band gap semiconductor material are GaAs, InSb, InP and CdS. Others will be known to those skilled in the art. Examples of direct band gap semiconductor materials are Ge and Si.

When considering an optical transition in a semiconductor material, crystal momentum is conserved. Since photons have very little momentum, direct optical transitions can only occur between conduction and valence band states that have the same value of wavevector *k*. In a direct semiconductor such as GaAs, the conduction band minimum and valence band maximum occur at the same value of *k* and direct combination of electrons and holes in the semiconductor can readily occur so as to produce photons. However, in an indirect semiconductor material the conduction and valence bands are configured differently and crystal momentum can only be conserved for the electron-hole combination, if an additional particle such as a momentum-conserving phonon is emitted or absorbed in order to produce a photon. Because this is a second-order process, the optical efficiency for indirect material such as silicon tends to be low relative to that of direct band gap semiconductors such as gallium arsenide.

Photoluminescence has been shown in porous silicon (with an indirect band gap) where microcrystallites of silicon exist in a silicon dioxide matrix. A review is given in "Porous Silicon: from Luminescence to LEDs" R.T. Collins et al, Physics Today, pp 24-31, January 1997. The origin of the effect is under discussion but one explanation is that the microcrystallites are sufficiently small that quantum charge carrier confinement occurs, dominated by the geometry of the structure rather than the bulk characteristics of the material itself.

A silicon based light emitting diode made of silicon is described in "Si-Based Light-Emitting Diode with Room-temperature Electroluminescence at 1.1 ev", Tsybeskov et al, Appl. Phys. Lett. 69, pp 3411-3413, (1996). However, the resulting device has limited switching speed and a wide emission spectrum. Furthermore, the emission properties of porous silicon degrade over time, if left for a few months in the air.

Photo-luminescence has been observed in quantum confined Si/SiO₂ superlattices, as described in "Quantum Confined Luminescence in Si/SiO₂ Superlattice", D. J. Lockwood et al, Phys. Rev. Lett. Vol 76, No. 3 pp 539-541. The device consisted of overlying layers of Si/SiO₂ in a superlattice grown at room temperature on a Si wafer. The resulting structure exhibited photoluminescence, apparently due to quantum confinement that produced direct band-to-band recombination of photo-induced charge carriers.

In our GB-A-2 275 820, an electroluminescent device is described in which quantum confinement is achieved by the formation of wires or pillars using electron beam lithography to achieve dimensions sufficiently small to produce quantum confinement and luminescence. Electrode structures are provided in order to inject charge carriers of opposite conductivity type into the silicon structure, in which charge carrier combination occurs to produce luminescence. However, the fabrication technique is not suitable as a commercial process because it is slow and expensive. Also, the emission efficiency from the silicon structures formed in this way is extremely low, probably because the percentage of the surface area of the device covered by the confined silicon regions is too low.

The present invention provides an improved electroluminescent device, susceptible to commercial manufacture with an improved emission efficiency.

The present invention provides an electroluminescent device comprising overlying layers of indirect band gap material, each with a sufficiently small layer thickness that the material exhibits direct band gap electroluminescent characteristics, and configured to receive electrical charge carriers such as to produce electroluminescence.

Electrically insulating layers may be disposed between the layers of indirect band gap material. The insulating layers may comprise tunnel barrier layers and the overall layer structure may comprise a superlattice.

The indirect band gap material may comprise silicon although other indirect band gap materials may be used.

The layers of indirect band gap material may have a thickness of 5 nm or less, in order to produce quantum confinement and typically have a thickness between 1 and 3 nm.

The insulating layers may be formed of SiO₂ or Si₃N₄ and may have a thickness of less than 3 nm in order to act as tunnel barriers.

Carrier injectors for injecting electrical charge carriers of different conductivity types into the layers may be provided in order to produce the electroluminescence. The injectors may comprise regions of p and n-doped semiconductors. The injectors may be operative to inject charge carriers of opposite conductivity types into the layers, transversely thereof or longitudinally.

The invention also includes a method of fabricating an electroluminescent device, comprising forming overlying layers of indirect band gap material, each with a sufficiently small layer thickness that the material exhibits direct band gap electroluminescent characteristics, and configuring the layers for receiving electrical charge carriers such as to produce electroluminescence.

The layers may be formed successively on a substrate with insulating layers formed between the layers of indirect band gap material.

In order that the invention may be more fully understood, embodiments thereof will now be described by way of example with reference to the accompanying drawings, in which:
Figure 1 is a schematic diagram of a layer structure in the form of a superlattice used in a device according to the invention;
Figure 2 is an energy band diagram for the superlattice shown in Figure 1;
Figure 3 illustrates schematically the configuration of the superlattice in a first, vertical device in accordance with the invention;
Figure 4 illustrates schematically a lateral device according to the invention;
Figure 5 illustrates schematically the layer configuration for a hybrid device in accordance with the invention;
Figure 6 is a schematic sectional view of the vertical device;
Figure 7 is a schematic sectional view of the lateral device;
Figure 8 is a schematic sectional view of the hybrid device;
Figure 9 is a schematic energy band diagram for the device of Figure 6, in which Figure 9a illustrates a condition of zero bias and Figure 9b illustrates a forward biased condition;
Figure 10 illustrates a series of process steps for manufacturing the vertical device of Figure 6;
Figure 11 is a schematic plan view of the mask structure of the device fabricated in accordance with Figure 10;
Figure 12 illustrates a series of process steps for fabricating the lateral device of Figure 7;
Figure 13 illustrates in plan view the mask pattern for the device fabricated according to Figure 12;
Figure 14 is an energy band diagram for the hybrid structure shown in Figure 8;
Figure 15 illustrates a series of process steps for fabricating the hybrid device of Figure 8;
Figure 16 is a schematic sectional view of an integrated circuit including a silicon transistor and an electroluminescent device in accordance with the invention; and
Figure 17 is a schematic circuit diagram of the integrated circuit shown in Figure 16.

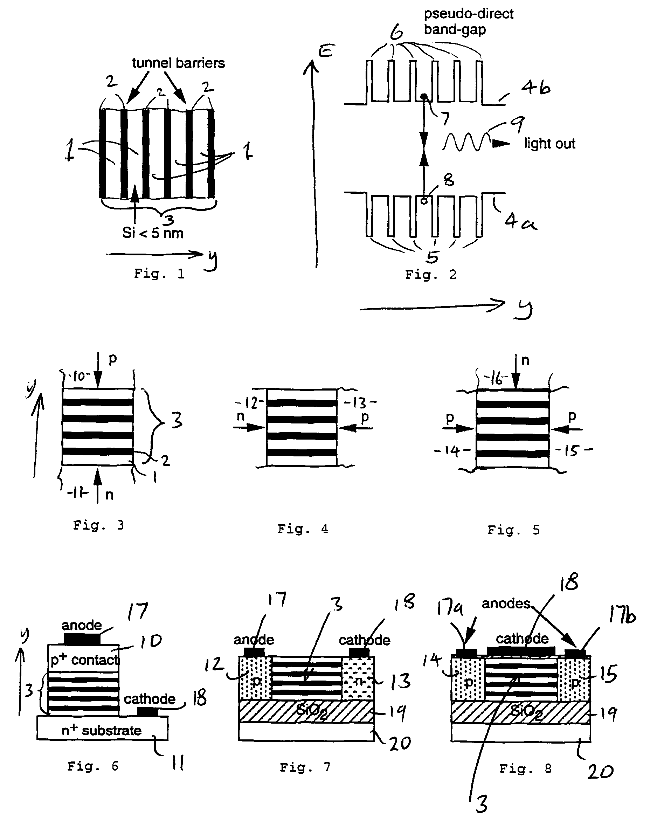

The following examples of electroluminescent devices in accordance with the invention are formed of overlying layers of indirect band gap material, namely silicon, confined between overlying layers of electrically insulating material. The layer structure is shown schematically in Figure 1 and consists of layers 1 of silicon between layers 2 of insulating silicon nitride. The layers 1 of silicon are made sufficiently thin that the material exhibits direct band gap electroluminescent characteristics. Typically, the silicon layers 1 are of a thickness of less than 5 nm for example between 1 and 3 nm. The insulating layers 2 may act as tunnel barriers and typically are of 3 nm in thickness. The layers 1 and 2 collectively form a layer structure 3.

Figure 2 illustrates the energy band diagram associated with the layer structure of Figure 1. The quantum confinement in the silicon layers 1 gives rise to a pseudo-direct band gap in the silicon. As shown in Figure 2, the layer structure has a valence band 4a and a conduction band 4b. The insulating layers 2 give rise to barriers 5, 6 in the valence and conduction bands 3, 4, with the result that the band states are confined such that they have the same value of wavevector *k*. As a result, an optical transition can occur when electron 7 from the conduction band 4 directly combines with a hole 8 from the valence band 3, causing a photon 9 to be emitted. The combination of hole and electron is a direct combination, notwithstanding the fact that silicon in its bulk state comprises an indirect band gap material. The effect of the layer structure is thus to confine the band gap of the silicon material in the layers 1 so that it exhibits a pseudo-direct band gap.

The wavelength λ of the electroluminescence peak is a function of the thickness d of the silicon layers, and ranges between approximately 530 nm for d = 1 nm to 740 nm for d = 3 nm. Above d = 3 nm and below d = 1nm the light intensity drops off.

Holes and electrons can be injected into the layer structure in a number of different ways, as shown in Figures 3, 4 and 5. Referring to Figure 3, p and n-type regions 10, 11 are formed above and below the layer structure 3 in order to inject electrons and holes in opposite directions i.e. vertically, upwardly and downwardly into the layer structure 3 such that the electrons and holes tunnel transversely through the insulating layers 2 into the silicon layers 1. Consequently, charge carrier combination occurs in the layers 1, which produces electroluminescence.

As shown in Figure 4, the p and n-type doped regions may be configured as regions 12, 13, laterally of the layer structure 3, so as to inject holes and electrons in opposite directions laterally along the silicon layers 1.

Figure 5 illustrates a modification in which p-type regions 14, 15 are disposed laterally of the layer structure 3 such that they both inject holes laterally along the layers 1, and an overlying region 16 injects electrons into the layer structure 3 such that they tunnel through the layers 2 transversely, to combine with the laterally injected holes and produce electroluminescence in the confined silicon layers 1.

Schematic device structures corresponding to the configurations of Figures 3, 4 and 5 are shown in Figures 6, 7 and 8 respectively.

Considering the device of Figure 6, the layer structure 3 is formed on a n⁺ doped substrate 11 and is overlaid by a p⁺ contact region 10. An anode and cathode 17, 18 are formed on the regions 10, 11 respectively. When a voltage is applied between the anode and cathode 17, 18, charge carriers of opposite conductivity types are drawn into the layer structure 3, so that the charge carriers tunnel through the insulating layers 2 into the silicon layers, where they combine directly to produce electroluminescence.

Referring to the device of Figure 7, the layer structure 3 is formed on an insulating layer of silicon dioxide 19, formed on a silicon wafer 20. The regions 12, 13 of opposite conductivity type are formed on opposite sides of the layer structure 3, and the anode and cathode 17, 18 overlie these regions. When a voltage is applied to the anode and cathode 17, 18, charge carriers of opposite conductivity type are injected laterally into the layers 1 of silicon, where they directly combine and produce electroluminescence.

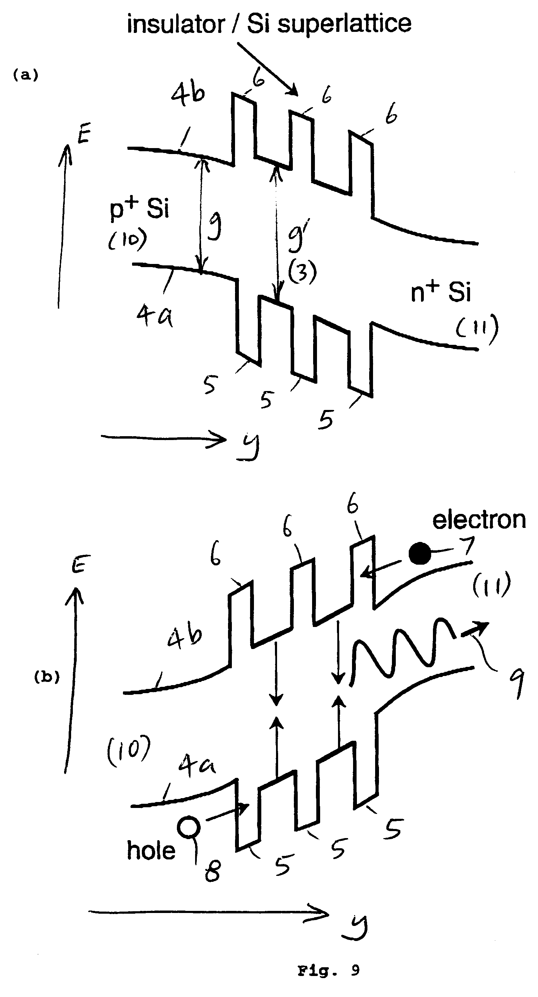

The device shown in Figure 8 is similar to the device of Figure 7 except that the regions 14, 15 are both p-type and each are provided with an overlying anode 17a, 17b respectively so as to inject charge carriers of the same conductivity type laterally into the layers 1 of the layer structure 3. A cathode 18 overlies the layer structure 3 and directly injects electrons transversely through the tunnel barrier layers 2 so as to combine with the holes injected from regions 14, 15 and produce electroluminescence.

The band structure for the device of Figure 6 will now be described in more detail with reference to Figure 9. The layer structure 3 lies in a depletion region between the p⁺ and n⁺ regions 10, 11. At zero bias, a built-in band-offset is established due to the redistribution of charge between the n and p-regions 10, 11. This is shown in Figure 9a. The band gap g' in the region of the confined silicon layers 1, is greater than the band gap g of the bulk silicon material and will increase depending on the width of the confinement provided by the layer structure 3.

Figure 9b illustrates the forward bias condition when a voltage is applied between the anode and cathode 17, 18 shown in Figure 6. Once the built-in potential is overcome, carriers from the n and p-regions 10, 11 tunnel into the quantum confined Si layers 1. Here they, combine across the pseudo-direct band gap and emit visible light. The wavelength of the light is determined by the width of the layers 1. Thus, it is possible to tailor the device to produce light emissions centred around a chosen region of the visible spectrum, by engineering the thicknesses of the layers 1.

It will be understood that the devices of Figures 7 and 8 operate in a similar way. However, in the embodiment of Figure 7, the charge carries do not need to tunnel through the insulating layers because they are injected laterally.

### Fabrication of vertical structure

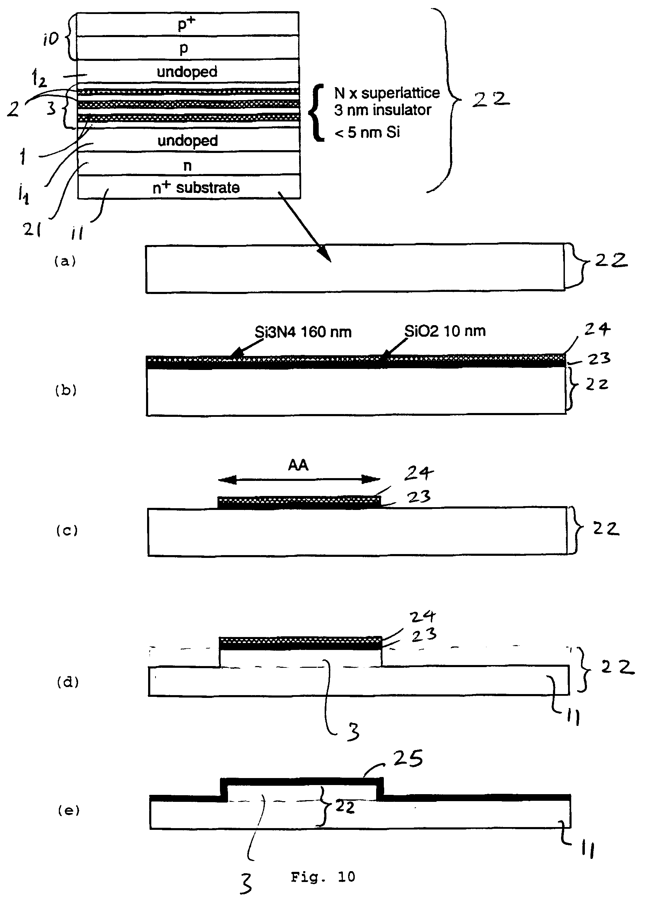

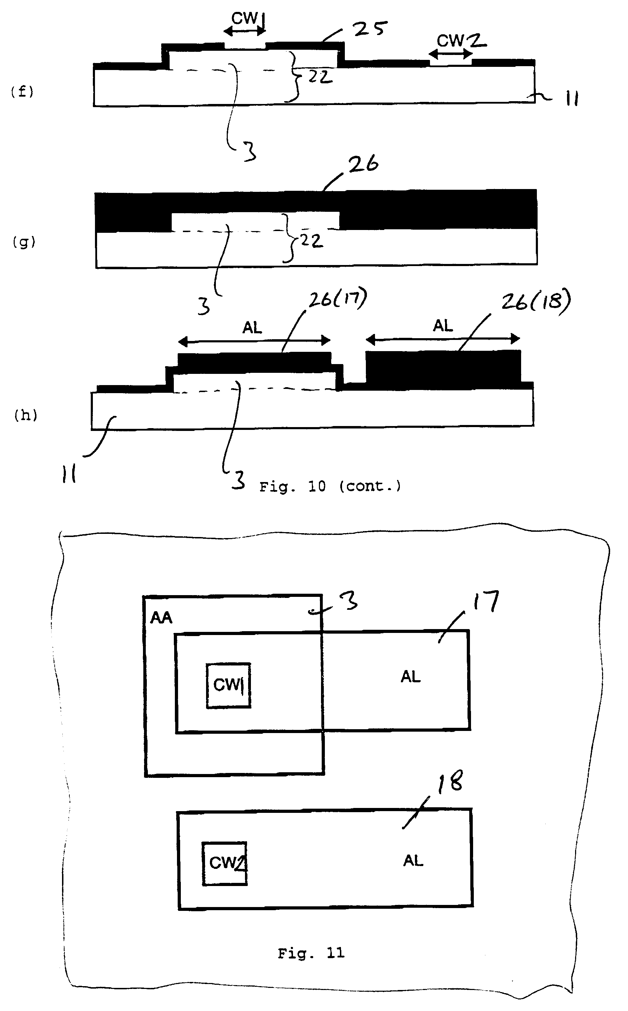

Fabrication of an example of the device configured vertically as shown in Figure 6, will now be described in detail with reference to Figure 10. The device structure is built up on the n⁺ silicon substrate 11. Initially, a 250 nm polysilicon layer 21 is deposited on the substrate 11 by low pressure chemical vapour deposition (LPCVD). A 10 nm thickness layer of silicon dioxide (not shown) is formed on the surface of the layer 21 by thermal oxidisation. Then the layer 21 is doped with arsenic by ion implantation so as to form a graded, doped structure. The oxide layer is then removed by wet etching using a 20:1 BHF solution.

Thereafter, a stack of the silicon and silicon nitride layers 1, 2 is grown so as to form the multiple layer structure 3, in the form of a superlattice. Initially, a layer 1₁ of silicon is deposited by LPCVD, typically of thickness 100 nm. The surface of the layer 1, is then thermally nitrided to form a thin, tunnel junction in which the thickness of the nitride is self-limited by to around 2-3 nm, with a tunnel barrier height of the order of 2eV. The method is described in more detail by M. Moslehi and K.C. Saraswat, IEEE Trans. Electron Device, ED 32, 106 (1985). Thereafter, another silicon layer 1 is deposited by LPCVD, typically at a temperature of 770°C in SiH₄ gas to achieve a thickness of the order of 5 nm. Thereafter, the surface of the deposited silicon is directly converted to silicon nitride at 930°C for 20 minutes in 100% NH3 gaseous atmosphere at 1 Torr. Then, a further silicon layer is deposited on the silicon nitride. Accordingly pure silicon nitride without any silicon oxide is formed between the successive deposited silicon layers. The process is repeated a number of times n so as to build up the layer structure 1, 2, with the silicon layers 1 being of a thickness between 1 and 3 nm and the silicon nitride layers 2 being of a thickness 2-3 nm. Typically n may have a value of 2 to 5.

Alternatively, the layers 2 may be formed of insulating, silicon dioxide. In this case, the silicon layers 1 can be grown using molecular beam epitaxy MBE and the SiO₂ barrier layers 2 can be formed using slow plasma oxidation.

The uppermost silicon layer 1₂ is thicker than the 5 nm underlying layer, and is typically 250 nm thickness.

A layer of polysilicon 10 is deposited onto the resulting layer structure 3, to a thickness of the order of 250 nm. The layer 10 is then doped with a p-type dopant e.g. boron, using ion implantation so as to be lightly doped in the vicinity of the layer structure 3 but heavily doped at its uppermost surface. The layer structure produced in this way, on the initial substrate 11, will hereinafter be referred to as the layer subassembly 22.

Referring to Figure 10b, a layer 23 of silicon dioxide is formed on the layer subassembly 22 by thermal oxidisation, to a thickness of 10 nm. Thereafter, a silicon nitride layer 24 is formed overlying the layer 23 by an LPCVD process at a temperature of 740°C.

Referring to Figure 10c, the silicon dioxide and silicon nitride layers 23, 24 are patterned using optical lithography and dry etching in an atmosphere of CHF₃ and argon gas, in a manner well known ***per se***. The resulting structure has a lateral width dimension AA.

As shown in Figure 10d, the patterned layers 23, 24 are then used as a mask in order to dry etch the layer subassembly 22 outside of the dimension AA. The etching is performed to a depth to remove the layer structure 3 outside of the dimension AA so as to expose either the layer 21 or the wafer 11 itself.

Then, as shown in Figure 10e, the patterned silicon nitride and silicon dioxide layers 23, 24 are removed using orthophosphoric acid and a 20:1 BHF solution, at a temperature of 160°C. A layer of silicon dioxide 25 is then formed by thermal oxidation, to a thickness of 100 nm.

Referring to Figure 10f, contact holes CW1, CW2 are formed in the silicon dioxide layer 25 by optical lithography and wet etching in a 20:1 BHF solution. The contact holes CW1, CW2 are to receive the anode and cathode 17, 18 shown in Figure 6.

Referring to Figure 10g, a metallisation layer 26 is formed by sputtering in order to provide the anode and cathode. The layer 26 comprises an initial layer of titanium of 100 nm thickness, overlaid by a 1000 nm thickness layer of aluminum/silicon (1%) produced by conventional sputtering techniques.

Then, as shown in Figure 10h, the anode and cathode 17, 18 are patterned in the layer 26 by conventional lithography and wet etching.

Figure 11 illustrates the mask layout of the resulting vertical device. The optically active area of the layer structure 3 lies within the area AA, and the resulting anode 17 formed from the layer 26 is configured not to overlie the area AA completely so as to minimise blockage of the emitted light.

### Fabrication of lateral structure

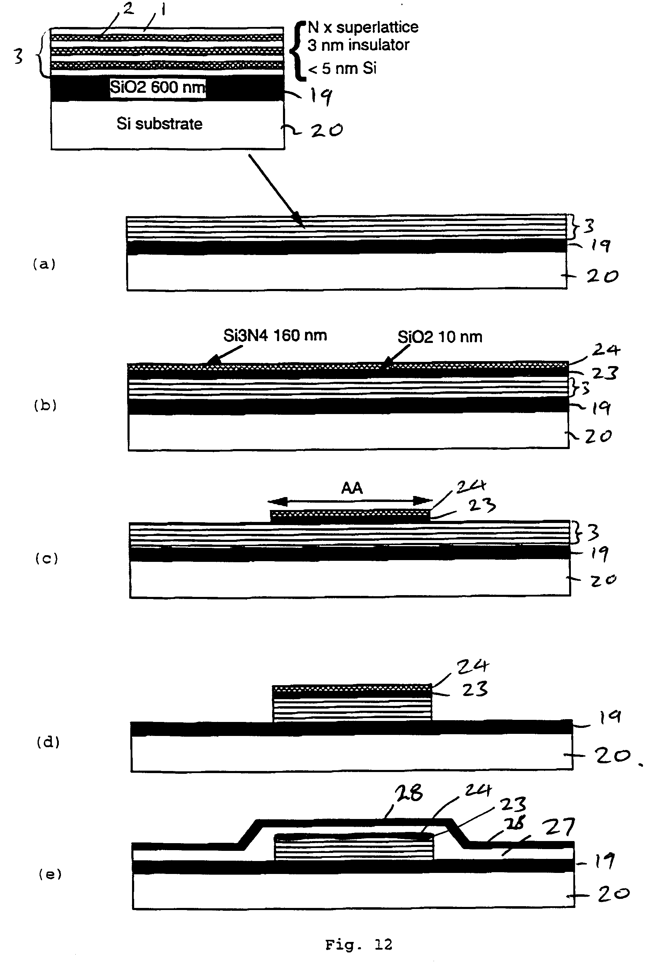

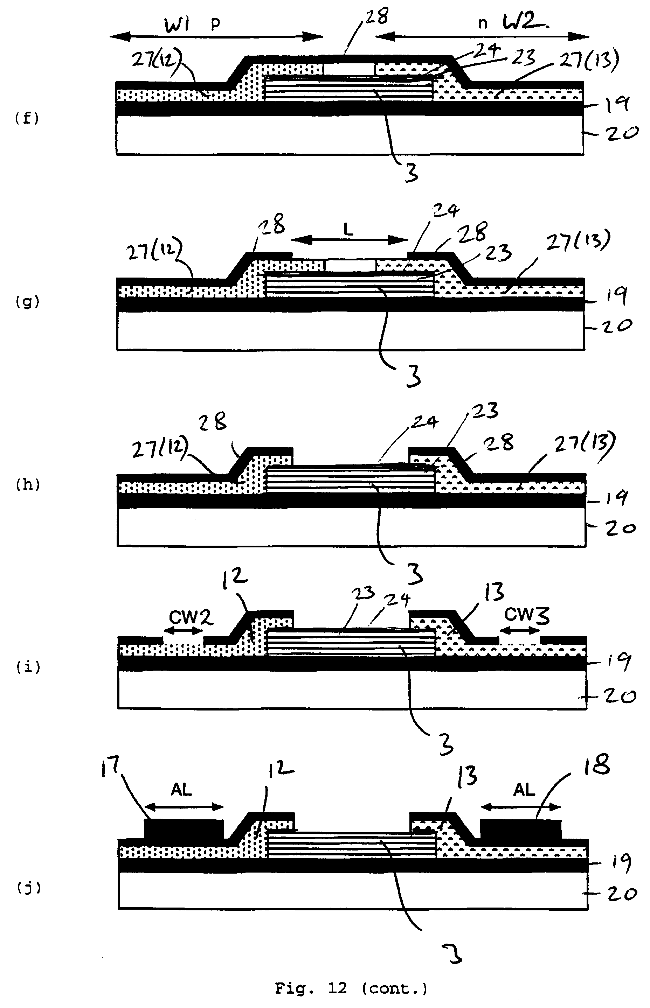

A method of fabricating a lateral device according to Figure 7 will now be described with reference to Figure 12.

Initially, silicon substrate 20 is thermally oxidised at 1000°C to form the layer of silicon dioxide 19, to a thickness of 600 nm. The superlattice layer structure 3 is then grown on the silicon dioxide layer 19 according to one of the methods previously described. In this example, the barrier layers 2 can be made relatively thick i.e. thicker than 3 nm because charge carriers do not need to tunnel through them; the charge carriers are injected laterally into the silicon layers 1, in this embodiment.

Then, as shown in Figure 12b, layers of silicon dioxide and silicon nitride 23, 24 of thicknesses 10 nm and 160 nm respectively are deposited by LPCVD at a temperature of 740°C, to provide mask layers in the manner described previously with reference to Figure 10b.

In Figure 12c, the mask layer is shown patterned to define an area AA. The patterning is performed by optical lithography or e-beam lithography followed by dry etching in an atmosphere of CHF₃ and argon gas.

Then, as shown in Figure 12d, using the etched layers 23, 24 as a mask, the superlattice layer structure 3 is etched, to a depth to pass through the entire superlattice.

Referring to Figure 12e, a thick Si layer is then deposited using LPCVD. The resulting silicon layer 27 is thick enough to cover the underlying layer structure 3 and the etched layers 23, 24. The surface of the layer 27 is converted to silicon dioxide by a thermal oxidation, to form an oxide layer 28.

Referring to Figure 12f, using optical or e-beam lithography, windows W1, W2 are defined, in order to define the extent of the laterally p and n-type carrier injection regions 12, 13 shown in Figure 7. Boron ions are injected through the window W1 into the silicon layer 27 to define the p-type carrier injection region 12. Similarly, arsenic ions are implanted through the window W2 so as to define the n-type charge carrier injection region 13 in the silicon layer 27. The remaining portion of the silicon nitride layer 24 acts as a screen to block the dopant atoms from reaching the layer structure 3, so that the silicon layers 1 therein, remain undoped during the ion implantation process.

Then, referring to Figure 12g, a window of width L is formed in the overlying silicon dioxide layer 28 by optical or e-beam lithography and etching in a 20:1 BHF solution.

As shown in Figure 12h, the silicon layer 27 and the remaining portions of the layers 23, 24 are then etched through the resulting window, down to the layer structure 3, so as to remove any direct electrical contact between the p and n-type carrier injection regions 12, 13.

Using optical lithography, contact windows CW2, CW3 are formed in the overlying oxide layer 28 and an anode and cathode 17, 18 are formed by sputtering Al/Ti, followed by optical lithography and wet etching, in the manner described previously with reference to Figures 10g and h.

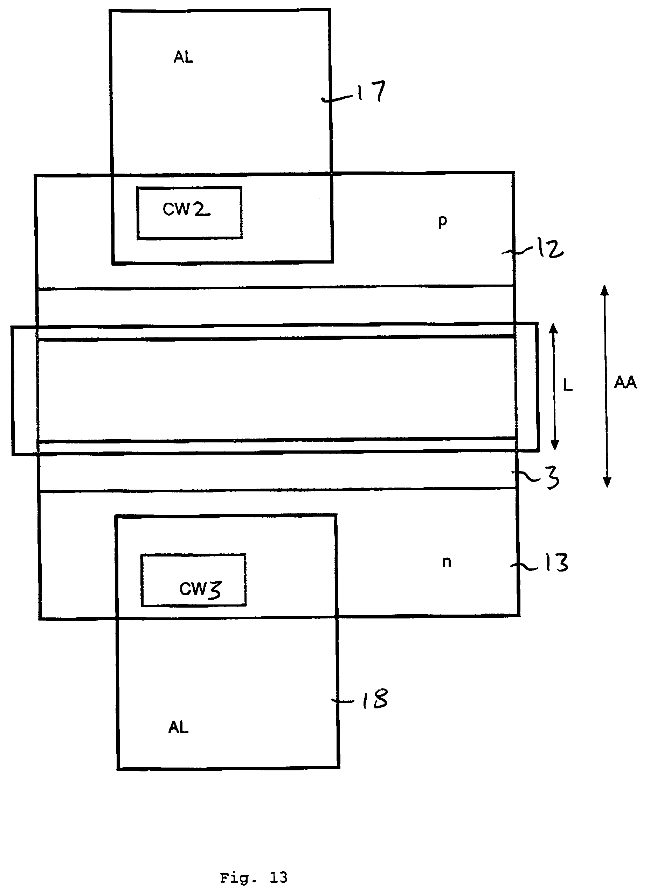

The mask layout for the resulting structure is shown plan view in Figure 13. The distance AA is selected to be less than 1 micron to ensure that the holes injected from the p-type injection region 12 pass laterally into the silicon layers 1 of the layer structure 3. The relatively short minority carrier mean free path in polycrystalline silicon, limits the maximum value of the dimension AA to around 1 micron

### Hybrid structure

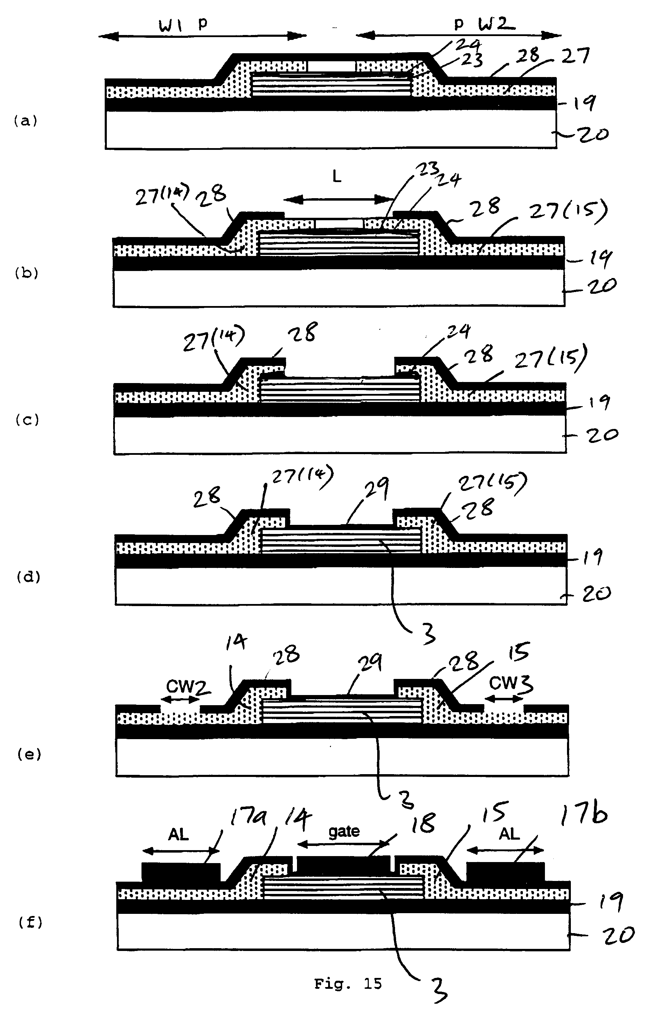

Figure 15 illustrates a series of process steps for fabricating the device shown schematically in Figure 8.

Initially, the substrate 20 is prepared in the manner described with reference to Figures 12a-e. As previously described, the windows W1 and W2 are defined using optical or e-beam lithography but in contrast to the previously described embodiment, boron ions are implanted through both of the windows in order to provide the two p-type charge injection regions 14, 15 shown in Figure 8. As previously described, the remaining portion of the silicon nitride layer 24 acts as a screen to prevent the dopant ions from entering the undoped silicon layers 1 in the superlattice layer structure 3. The resulting structure is shown in Figure 15a.

Then, as shown in Figure 15b, a window of width L is formed in the silicon dioxide layer 28 by e-beam or optical lithography and etching using a 20:1 BHF solution.

Referring to Figure 15c, the LPCVD deposited silicon layer 27 is etched in an atmosphere of CH₄ gas. The silicon layer 27 is etched down to expose the superlattice layer structure 3.

Then, as shown in Figure 15d, a thin gate oxide layer 29 is formed over the exposed part of the layer structure 3, using a dry oxidation process. The thickness of the gate oxide layer is of the order of 20 nm.

Referring to Figure 15e, contact windows CW2, CW3 are formed in the oxide layer 28, to receive the anodes of the device.

Referring to Figure 15f, the anodes 17a, 17b and the gate 18 are formed using sputter of Al/Ti, optical lithography and wet etching, in the general manner previously described with reference to Figures 10g and h.

The resulting structure thus allows carriers to be injected both laterally and vertically into the silicon layers 1 of the superlattice layer structure 3. In this case, holes are injected laterally from the carrier injection regions 14, 15, into the silicon layers 1 of the superlattice layer structure 3. Also, electrons are injected from the cathode or gate 18 transversely through the tunnel barrier layers 2, through the insulating tunnel gate oxide layer 29, where they combine with the injected holes to produce photoluminescence. A negative bias is applied to the gate 18. At low values of bias voltage, the gate initially creates a p-type inversion channel, but at higher bias hot electrons are injected into the layer structure 3 to produce electroluminescence in a plurality of the confined silicon layers 1.

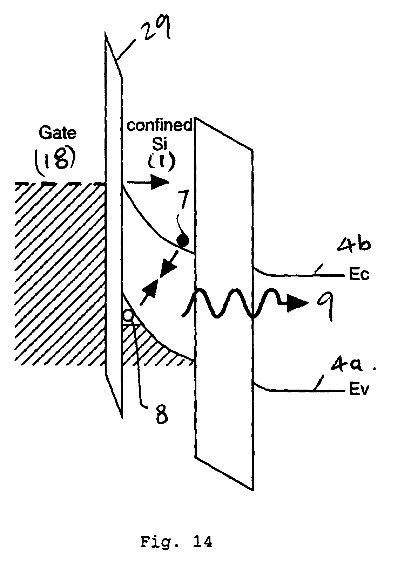

The energy band diagram for the device of Figure 8 is shown in Figure 14, from which it can be seen that electrons which tunnel through the tunnel oxide layer 29 into the conduction band of the layers 1, can combine with holes injected from the anodes injected from the p-type regions 14, 15, directly, due to the pseudo-direct band gap of the silicon material 1. A direct combination of electron 7 hole 8 is shown, to produce a photon 9.

### Integrated Circuit

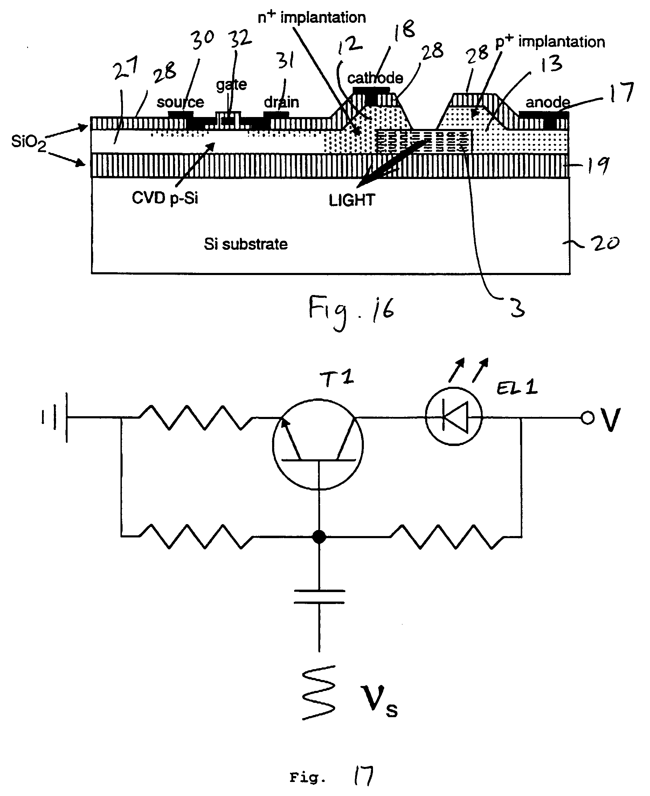

The described examples of the invention have the advantage that because they are made of silicon they can be integrated into silicon based electrical circuits to provide optoelectronics on a common Si substrate. An example of this integration is shown in Figure 16 and the corresponding circuit diagram is shown in Figure 17.

The device shown in Figure 16 consists of an electroluminescent device EL1 formed as a lateral structure as described with reference to Figures 7 and 12, connected to a transistor T1. The combined circuit is formed on the substrate 20 and the overlying layer 19 of silicon dioxide. The LPCVD deposited silicon layer 27 which is doped to provide the n and p-type charge carrier injection regions 12, 13, together with the overlying oxide layer 28 are used also for the transistor T1. Source and drain regions 30, 31 together with a gate 32 for the transistor T1, are formed in the oxide layer 28 in a manner well known ***per se**.* The drain 31 is directly connected to the cathode 18 of EL1 through the silicon layer 27. The doping process which forms the n⁺ doped charge injection region 12 is extended up to the drain of the transistor T1 so as to provide a direct connection between the drain 31 of the transistor and the charge carrier injection region 12, through the resulting, conductive silicon layer 27.

In use, the bias voltage V is applied between the source 30 of the transistor and the anode 17 of EL1. An electrical signal is applied to the gate 32 of transistor T1 and as a result, the electrical signal is applied between the charge carrier injection regions 12, 13, to inject charge carriers into the superlattice layer structure 3, with the result that optical radiation is emitted from the layer structure as a function of the applied electrical signal Vₛ.

It will be appreciated that an optical fibre may be used to direct light from the layer structure 3 into an optical telecommunications network. Alternatively, optical integrated circuit waveguides may be formed on the chip to route the light away from EL1, the waveguides being formed by a conventional method, well known to those skilled in the art.

Whilst the described embodiments of the invention use silicon as the bulk indirect band gap semiconductor, it will be appreciated that other such indirect band gap semiconductor materials could be used, for example Ge. Also, whilst the described layer structure consists of doped layers of semiconductor, it will be appreciated that separate, non-doped insulating layers could be used between the confined layers of indirect band gap material.

As used herein, the term "light" includes both visible and non-visible optical radiation including, but not limited to ultraviolet and infrared.

## Claims

1. An electroluminescent device comprising overlying layers of indirect band gap material, each with a sufficiently small layer thickness that the material exhibits direct band gap electroluminescent characteristics, and configured to receive electrical charge carriers such as to produce electroluminescence.

2. A device according to claim 1 including electrically insulating layers disposed between the layers of indirect band gap material.

3. A device according to claim 2 wherein the insulating layers comprise tunnel barrier layers.

4. A device according to claim 2 or 3 wherein each of the layers of indirect band gap material is directly overlaid by a respective one of the insulating layers.

5. A device according to any preceding claim wherein the layers form a superlattice.

6. A device according to any preceding claim wherein the indirect band gap material comprises silicon.

7. A device according to any preceding claim wherein the layers of indirect band gap material have a thickness of less than 5 nm.

8. A device according to claim 7 wherein the layers of indirect band gap material have a thickness of between 1 nm and 3 nm.

9. A device according to claim 2, 3 or 4 wherein the insulating layers are formed of SiO₂ or Si₃N₄.

10. A device according to claim 2, 3 or 4 wherein the insulating layers are of a thickness of less than 3 nm

11. A device according to any preceding claim including and carrier injectors for injecting electrical charge carriers of different conductivity types into the layers to produce electroluminescence.

12. A device according to claim 12 wherein the or each of the carrier injectors is operative to inject charge carriers of opposite conductivity type into the layers transversely thereof.

13. A device according to claim 12 wherein the or each of the carrier injectors is operative to inject charge carriers of opposite conductivity type into the layers longitudinally thereof.

14. A device according to any one of claims 12 to 14 wherein the charge carriers are operative to inject carriers of opposite conductivity type into the layers in different directions.

15. A device according to claim 15 wherein the charge carriers are operative to inject carriers of opposite conductivity type into the layers in opposite directions.

16. A device according to claim 15 wherein the charge carriers are operative to inject carriers of opposite conductivity type into the layers in generally orthogonal directions.

17. A method of fabricating an electroluminescent device, comprising forming overlying layers of indirect band gap material, each with a sufficiently small layer thickness that the material exhibits direct band gap electroluminescent characteristics, and configuring the layers for receiving electrical charge carriers such as to produce electroluminescence.

18. A method according to claim 17 including forming electrically insulating layers between the layers of indirect band gap material.

19. A method according to claim 17 or 18 forming the layers in a superlattice.

20. A method according to any one of claims 17 to 19 including forming the layers of indirect band gap material with a thickness of less than 5 nm.

21. A method according to claim 20 including forming the layers of indirect band gap material with a thickness of between 1 nm and 3 nm.

22. A method according to claim 18 or 19 including forming the insulating layers with a thickness of less than 3 nm.

23. A method according to any one of claims 17 to 22 including successively forming the layers on a substrate by doping.

24. A method according to any one of claims 17 to 22 including forming carrier injectors for injecting electrical charge carriers of different conductivity types into the layers to produce the electroluminescence.

25. A method according to claim 24 wherein the carrier injectors are formed by doping different regions of the device to be of different conductivity types, for causing electrical charge carriers of different conductivity types to be injected into the layers.

26. An electroluminescent device fabricated by a method according to any one of claims 17 to 25.

27. An electroluminescent device according to any one of claims 1 to 16, incorporated in an integrated circuit with a circuit element formed of said indirect band gap material.

28. An electroluminescent device according to claim 27 wherein the circuit element comprises a transistor.
